# EUROPÄISCHE PATENTSCHRIFT

(11) **EP 1 862 567 B1**
(45) Veröffentlichungstag und Bekanntmachung des Hinweises auf die Patenterteilung: **16.12.2009**
(21) Anmeldenummer: 07109111.0
(22) Anmeldetag: 29.05.2007
(51) Int. Cl.: C23C 16/54, C23C 14/56

(54) **Verfahren zur Abdichtung einer Vakuumkammer und Schleuseneinrichtung für eine Vakuumkammer**
Method of sealing a vacuum chamber and sluice device for a vacuum chamber
Procédé destiné à l'étanchéification d'une chambre à vide et dispositif d'écluse pour une chambre à vide

(30) Priorität: 31.05.2006 DE 102006025751
(43) Veröffentlichungstag der Anmeldung: 05.12.2007
(73) Patentinhaber: VON ARDENNE ANLAGENTECHNIK GMBH, 01324 Dresden (DE)
(72) Erfinder: Gottsmann, Lutz, 01900 Kleinröhrsdorf (DE); Laimer, Georg, 01662 Meißen (DE); Jaeger, Reinhard, 01640 Coswig (DE)
(74) Vertreter: Lippert, Stachow & Partner

(56) Entgegenhaltungen:
- JP-A- 1 042 578
- US-A- 3 640 543

## Beschreibung

Die Erfindung betrifft ein Verfahren zum Transport bandförmiger Substrate durch eine Vakuumkammer sowie eine Schleuseneinrichtung für eine Vakuumkammer.

Bei air to air Vakuumbeschichtungsanlagen sind eingangs- und ausgangsseitig Schleuseneinrichtungen notwendig, um kontinuierlich Metallband von Atmosphäre in Vakuumprozessbehälter hinein bzw. aus Vakuumprozessbehältern heraus zu transferieren, ohne dass der erforderliche Prozessdruck des der eingangsseitigen Schleusensektion folgenden bzw. vor der ausgangsseitigen Schleusensektion befindlichen Vakuumbehälters beeinflusst wird.

Bandschleusen nach dem Prinzip von Spaltgeometrie (Band durchläuft in der Ein- bzw. Ausgangschleuse einen oder mehrere Spalte) sind technisch aufgrund extrem großer Leckagen und der damit verbunden Notwendigkeit großer zu installierender Saugleistung der Vakuumpumpen kaum realisierbar.

Bandschleusen mit mehreren rotierenden Dichtrollen sind in verschiedenen Ausführungsformen bekannt, wobei das Grundprinzip jeweils durch eine Abdichtung sowohl zwischen Band und rotierender Dichtrolle als auch zwischen rotierender Dichtrolle und Ein- bzw. Ausgangschleusenbehälter gewährleistet wird. Ein Beispiel derartiger Schleuseneinrichtungen ist in JP 01 042578 A beschrieben, bei der zwei Dichtungswalzen in Abhängigkeit von der Dicke und Breite des Metallbands gegeneinander verschoben werden können.

Es sind sowohl Dichtrollen mit gummierter als auch mit metallischer Oberfläche bekannt.

Dichtrollen mit gummierter Oberfläche sind aufgrund ihrer eingeschränkten thermischen Belastbarkeit nicht allumfassend einsetzbar.

Dichtrollen mit metallischer Oberfläche sind thermisch wesentlich belastbarer, da sie z. B. auch intern mit Wasser kühlbar sind. Ein Nachteil der Dichtrollen mit metallischer Oberfläche besteht aber darin, dass die erforderliche Traktion zwischen Band und Dichtrolle (die Rolle soll möglichst ohne fremden Antrieb passiv vom Band getrieben werden) zur Erzeugung einer zur linearen Bandgeschwindigkeit 100%ig gleichlaufenden Umfangsgeschwindigkeit der Dichtrolle durch einen relativ geringen Reibwert zwischen Band und Dichtrolle übertragen werden muss. Eine Verbesserung der Traktion zwischen Band und Dichtrollen lässt sich entweder durch Erhöhung des Bandzuges (Kraft mit der das Band durch die Bandschleuse gezogen wird) oder durch eine Erhöhung des Umschlingungswinkels Band um Dichtrolle erzielen.

Große Umschlingungswinkel erfordern bei vergleichsweise dicken Bändern auch sehr große Rollendurchmesser, um eine Schädigung des Bandes durch eine zu starke Krümmung zu vermeiden. Andererseits kann bei vergleichsweise dünnen Bändern der Bandzug nur innerhalb zulässiger (materialabhängiger) Werte erhöht werden, anderenfalls kann das Band geschädigt werden.

Aus DD 289 297 A5 ist eine Bandschleuse für Vakuumbeschichtungsanlagen bekannt, bei der jeweils die obere Rolle eines Rollenpaares vertikal beweglich und differenzdruckabhängig anhebbar ist.

DE 2 260 683 offenbart eine Schleuseneinrichtung, bei der das bandförmige Substrat eine Reihe hintereinander angeordneter Rollen passiert, wobei das Substrat abwechselnd die Oberseite und die Unterseite angrenzender Rollen umschlingt und die Rollen zur Kammerwand durch Dichtelemente in Form von Spaltschleusen abgedichtet sind.

Bei den Schleuseneinrichtungen gemäß EP 0 293 929 A1 und EP 0 388 811 A1 ist zwischen zwei Führungsrollen 25, deren höchste Mantellinien in der Transportebene des Substrats liegen, eine zugabhängig senkrecht zu dieser Transportebene verstellbare Spannrolle 26 vorgesehen, um den Umschlingungswinkel und die Bandzugkraft einzustellen. Eine ähnliche Lösung ist auch in EP 1 004 369 B1 dargestellt.

Eine Aufgabe der vorliegenden Erfindung besteht daher darin, ein Verfahren zur Abdichtung einer Vakuumkammer anzugeben, das ein Einschleusen und Ausschleusen eines bandförmigen Substrats in eine bzw. aus einer Vakuumkammer so ermöglicht, dass eine wirksame Abdichtung der Vakuumkammer zur Atmosphäre erzielt wird und dass Beschädigungen des Substrats durch zu große Verformungen des Substrats oder zu hohe Bandzugkräfte vermieden wird. Eine weitere Aufgabe der Erfindung ist es, eine Schleuseneinrichtung für eine Vakuumkammer anzugeben, welche gleichermaßen und universell sowohl für dünne Bänder mit vergleichsweise geringen Bandzugkräften und großen ertragbaren Biegeverformungen als auch für dicke Bänder mit vergleichsweise hohen Bandzugkräften und kleinen ertragbaren Biegeverformungen geeignet ist, wobei für alle Banddicken dieselben Rollen mit relativ kleinen Rollendurchmessern verwendbar sind.

Erfindungsgemäß werden diese Aufgaben gelöst durch ein Verfahren zur Abdichtung einer Vakuumkammer gegen Atmosphäre mit den Merkmalen des Anspruchs 1 sowie eine Schleuseneinrichtung für eine Vakuumkammer zur Behandlung eines bandförmigen Substrats mit den Merkmalen des Anspruchs 13. Vorteilhafte Weiterbildungen der Erfindung sind Gegenstand der abhängigen Ansprüche.

Das erfindungsgemäße Verfahren zur Abdichtung einer Vakuumkammer gegen Atmosphäre, bei dem ein bandförmiges Substrat durch die Vakuumkammer transportiert wird, wobei das bandförmige Substrat zwischen zwei um je eine Rotationsachse drehbar gelagerten Rollen eines Rollenpaares hindurchgeführt wird, die mit einem eine Bandpassage für das bandförmige Substrat bildenden Abstand zueinander angeordnet sind, ist dadurch gekennzeichnet, dass der Umschlingungswinkel zwischen dem bandförmigen Substrat und jeder Rolle durch Verdrehung des Rollenpaars relativ zur Transportrichtung des bandförmigen Substrats so eingestellt wird, dass die zwischen dem bandförmigen Substrat und den Rollen wirkenden Reibungskräfte eine Rotationsbewegung der Rollen hervorrufen, bei der die Umfangsgeschwindigkeit der Rollen im Wesentlichen gleich der Transportgeschwindigkeit des bandförmigen Substrats ist.

In einer Weiterbildung der Erfindung wird der Abstand zwischen den Rollen durch eine Bewegung mindestens einer Rolle eines Rollenpaares relativ zur anderen Rolle des Rollenpaares an die Dicke des bandförmigen Substrats angepasst.

In einer ersten Ausgestaltung ist die relative Bewegung der mindestens einen Rolle eine Verschiebung.

In einer weiteren Ausgestaltung ist die relative Bewegung der mindestens einen Rolle eine Schwenkbewegung um eine außerhalb der Rotationsachse der Rolle liegende Schwenkachse.

Vorteilhaft wird zur Anpassung des Abstandes an ungleichmäßig dicke bandförmige Substrate mindestens eine Rolle eines Rollenpaares mit einer Andruckkraft beaufschlagt, deren Richtung im Wesentlichen der Verbindungslinie zwischen den Rotationsachsen der beiden Rollen entspricht.

Zur weiteren Verbesserung der Abdichtung der Vakuumkammer kann vorgesehen sein, dass das bandförmige Substrat durch mindestens zwei hintereinander angeordnete Rollenpaare hindurchgeführt wird. Vorteilhaft kann dabei vorgesehen sein, dass die Verdrehung jedes Rollenpaares relativ zur Transportrichtung des bandförmigen Substrats separat eingestellt wird.

Zur Erhöhung der Genauigkeit des Verfahrens ist nach einer bevorzugten Weiterbildung der Erfindung vorgesehen, dass die Verdrehung jedes Rollenpaares gesteuert oder geregelt wird. In einer Ausgestaltung dieser Weiterbildung der Erfindung erfolgt die Steuerung bzw. Regelung in Abhängigkeit von der Dehnung des bandförmigen Substrats oder/und von der Bandzugkraft.

Bei dem erfindungsgemäßen Verfahren kann vorteilhaft vorgesehen sein, dass die Breite der Bandpassage für das bandförmige Substrat auf einen Wert eingestellt wird, der der tatsächlichen Breite des bandförmigen Substrats entspricht. Die Einstellung der Breite der Bandpassage kann vorteilhaft durch Verschieben mindestens einer verschiebbaren Blende erfolgen.

Die erfindungsgemäße Schleuseneinrichtung für eine Vakuumkammer zur Behandlung eines bandförmigen Substrats umfasst mindestens ein Rollenpaar, das von zwei um je eine Rotationsachse drehbar gelagerten Rollen gebildet ist, wobei die Rollen mit einem eine Bandpassage für das bandförmige Substrat bildenden Abstand zueinander angeordnet sind, und ist dadurch gekennzeichnet, dass das Rollenpaar relativ zur Transportrichtung des bandförmigen Substrats drehbar gelagert ist.

In einer Weiterbildung der Erfindung ist vorgesehen, dass beide Rollen eines Rollenpaares in einem relativ zur Transportrichtung des bandförmigen Substrats drehbar gelagerten Hohlzylindersegment mit einer Transferöffnung gelagert sind. Damit steht eine definierte Oberfläche zur Verfügung, die die Abdichtung der Schleuseneinrichtung gegenüber einer Schottwand der Vakuumkammer, in die sie eingebaut ist, ermöglicht.

Dabei kann das Hohlzylindersegment in einem Ausschnitt einer Flanschplatte, die zur Anbringung an einer Schottwand der Vakuumkammer ausgebildet ist, so gelagert sein, dass seine Außenseite bei einer Verdrehung in ständigem Kontakt mit den Rändern des Ausschnitts steht. Dies ist vorteilhaft, um eine gute Abdichtung zu erzielen.

In einer Ausgestaltung der Erfindung ist vorgesehen, dass an den Rändern des Ausschnitts Dichtmittel zur Abdichtung des Hohlzylindersegments gegenüber der Flanschplatte vorgesehen sind. In einer weiteren Ausgestaltung der Erfindung ist vorgesehen, dass das Hohlzylindersegment weiterhin Dichtmittel zur Abdichtung der Rollen gegenüber dem Hohlzylindersegment aufweist. Dadurch werden die Spalte zwischen den beweglichen Bauteilen untereinander und zur Flanschplatte oder Schottwand der Vakuumkammer weiter minimiert, so dass das Druckgefälle zwischen den beiden Seiten einer Schleuseneinrichtung aufrechterhalten wird.

Gemäß einer Weiterbildung der Erfindung weist das Hohlzylindersegment mindestens eine beweglich gelagerte Blende zur Einstellung der Breite der Transferöffnung auf. Dabei ist die Blende vorteilhaft gegenüber dem Hohlzylindersegment durch weitere Dichtmittel abgedichtet. Durch Verstellen der Blende oder Blenden ist es möglich, die Breite der Transferöffnung an die tatsächliche Breite des Substrats anzupassen, so dass die Schleuseneinrichtung für verschiedene Substratbreiten verwendbar ist.

Weiter vorteilhaft kann vorgesehen sein, dass an der mindestens einen beweglich gelagerten Blende eine Seitenwange vorgesehen ist, die eine zum Querschnitt des Rollenpaares komplementäre Form aufweist. Hierdurch wird eine Abdichtung zwischen der beweglichen Blende und den Rollen auch quer zur Substratebene erreicht, die in einer bevorzugten Ausgestaltung der Erfindung durch Dichtmittel verbessert sind, die an den die Rollen berührenden Flanken der Seitenwangen angeordnet sind.

In einer weiteren Ausgestaltung der Erfindung ist mindestens eine Rolle des Rollenpaares relativ zur anderen Rolle des Rollenpaares zur Anpassung des Abstands an die Dicke des bandförmigen Substrats bewegbar. Dabei kann die bewegbare Rolle vorteilhaft verschiebbar oder um eine außerhalb der Rotationsachse dieser Rolle liegende Schwenkachse schwenkbar gelagert sein.

Zur Anpassung des Abstandes an ungleichmäßig dicke bandförmige Substrate kann mindestens eine Rolle eines Rollenpaares mit einer Andruckkraft beaufschlagbar sein, deren Richtung im Wesentlichen der Verbindungslinie zwischen den Rotationsachsen der beiden Rollen entspricht.

Zur Erzeugung der Andruckkraft kann ein Pneumatikzylinder vorgesehen sein. Alternativ kann die Andruckkraft durch eine Feder, die beispielsweise als Schraubenfeder oder als Spiralfeder ausgeführt sein kann, oder durch andere geeignete Mittel erzeugt werden.

Zur Verbesserung der Abdichtung der Vakuumkammer gegenüber der Atmosphäre sind vorteilhaft mindestens zwei hintereinander angeordnete Rollenpaare vorgesehen.

In einer Weiterbildung der erfindungsgemäßen Schleuseneinrichtung sind die Verdrehung jedes Rollenpaares oder/und der Abstand der Rollen jedes Rollenpaares verschiedener hintereinander angeordneter Schleuseneinrichtungen relativ zur Transportrichtung des bandförmigen Substrats separat einstellbar. Dadurch ist es beispielsweise möglich, einzelne Schleuseneinrichtungen zu öffnen. Dies kann beispielsweise nötig sein, wenn die Rollen einer Schleuseneinrichtung verschmutzt sind, um nicht den gesamten Prozess stoppen zu müssen.

Vorteilhaft können weiterhin Mittel zur Steuerung oder/und Regelung der Verdrehung jedes Rollenpaares vorgesehen sein. In einer Ausgestaltung der Erfindung sind weiterhin Mittel zur Messung der Dehnung oder/und der Bandzugkraft des bandförmigen Substrats vorgesehen.

Nachfolgend wird die Erfindung anhand von Ausführungsbeispielen und zugehörigen Zeichnungen näher erläutert. Dabei zeigen:
Fig. 1 ein erstes Ausführungsbeispiel der Schleuseneinrichtung in einer ersten Einstellung,
Fig. 2 das Ausführungsbeispiel aus Fig. 1 in einer zweiten Einstellung,
Fig. 3 ein zweites Ausführungsbeispiel in einer Seitenansicht,
Fig. 4 das zweite Ausführungsbeispiel in der Draufsicht,
**Fig. 5** eine Schnittdarstellung B-B gemäß Fig. 3,
Fig. 6 eine Schnittdarstellung C-C gemäß Fig. 3,
Fig. 7 eine Schnittdarstellung A-A gemäß Fig. 4,
Fig. 8 eine isometrische Ansicht des zweiten Ausführungsbeispiels.

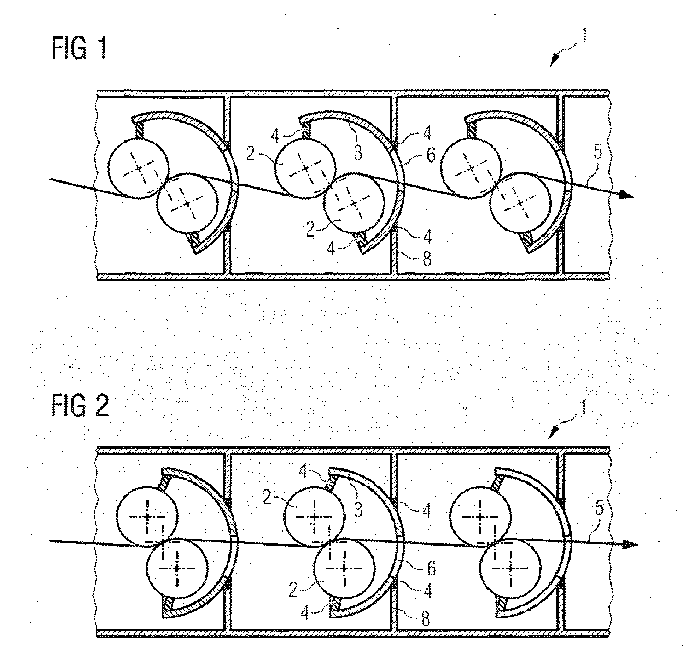

Die Fig. 1 und 2 zeigen ein erstes Ausführungsbeispiel der erfindungsgemäßen Schleuseneinrichtung. In einer Vakuumkammer 1 ist durch Anordnung mehrerer erfindungsgemäßer Schleuseneinrichtungen ein Eingangsschleusenbereich gebildet.

Die Schleuseneinrichtungen umfassen jeweils ein in einer Öffnung einer Schottwand 8 drehbar gelagertes Hohlzylindersegment 3, an dem ein aus zwei Rollen 2 bestehendes Rollenpaar angeordnet ist. Die Rollen 2 sind jeweils drehbar gelagert und die obere Rolle 2 ist relativ zur unteren Rolle beweglich so gelagert, dass der die Bandpassage bildende Abstand der Rollen 2 zueinander auf die Dicke des bandförmigen Substrats 5 einstellbar ist.

Die Öffnungen der Schottwände 8 weisen an ihren Rändern Dichtmittel 4 auf, die im ständigen Kontakt mit den Mantelflächen der Hohlzylindersegmente 3 stehen, um eine Abdichtung zwischen den Hohlzylindersegmenten 3 und der jeweiligen Schottwand 8 zu erzielen. In gleicher Weise sind im Hohlzylindersegment 3 weitere Dichtmittel 4 zur Abdichtung zwischen den Rollen 2 und dem Hohlzylindersegment 3 vorgesehen.

Die Hohlzylindersegmente 3 weisen eine Transferöffnung 6 auf. Das bandförmige Substrat 5 wird bei jeder Schleuseneinrichtung zunächst durch den Spalt zwischen den Rollen 2 und anschließend durch die Transferöffnung 6 des Hohlzylindersegments 3 geführt. Durch die effektive Abdichtung der Bauelemente zueinander entstehen in den zwischen je zwei Schottwänden 8 befindlichen Räumen unterschiedliche Druckniveaus, so dass der Atmosphärendruck außerhalb der Vakuumkammer 1 mit jeder Schleuseneinrichtung schrittweise auf das in der Vakuumkammer 1 benötigte Prozessvakuum abgesenkt wird.

Die Drehung des Hohlzylindersegments 3 bewirkt, dass auch das Rollenpaar relativ zur Vakuumkammer 1 und zur Transportrichtung des bandförmigen Substrats 5 gedreht wird. Dadurch ändert sich der Umschlingungswinkel des bandförmigen Substrats 5 um die Rollen 2. Auf diese Weise kann erreicht werden, dass das bandförmige Substrat 5 nicht überbeansprucht wird. Gleichzeitig wird die Reibung zwischen den Rollen 2 und dem bandförmigen Substrat so beeinflusst, dass die Umfangsgeschwindigkeit der Rollen 2 im Wesentlichen identisch zur Transportgeschwindigkeit des bandförmigen Substrats 5 ist.

Fig. 1 zeigt die Schleuseneinrichtungen in einer ersten Einstellung, bei der der Umschlingungswinkel des bandförmigen Substrats 5 um die Rollen 2 relativ groß ist, während bei der Einstellung gemäß Fig. 2 ein relativ kleiner Umschlingungswinkel gewählt ist. Selbstverständlich ist es auch möglich, bei mehreren Schleuseneinrichtungen wie hier dargestellt einzelnen Schleuseneinrichtungen verschiedene Umschlingungswinkel zuzuweisen, indem die Verdrehung der Hohlzylindersegmente 3 oder der Rollenpaare unterschiedlich eingestellt wird. In gleicher Weise ist es möglich, einzelne Rollenpaare durch Vergrößerung des Abstands zwischen den beiden Rollen 2 so einzustellen, dass das bandförmige Substrat 5 diese Schleuseneinrichtung berührungslos durchläuft.

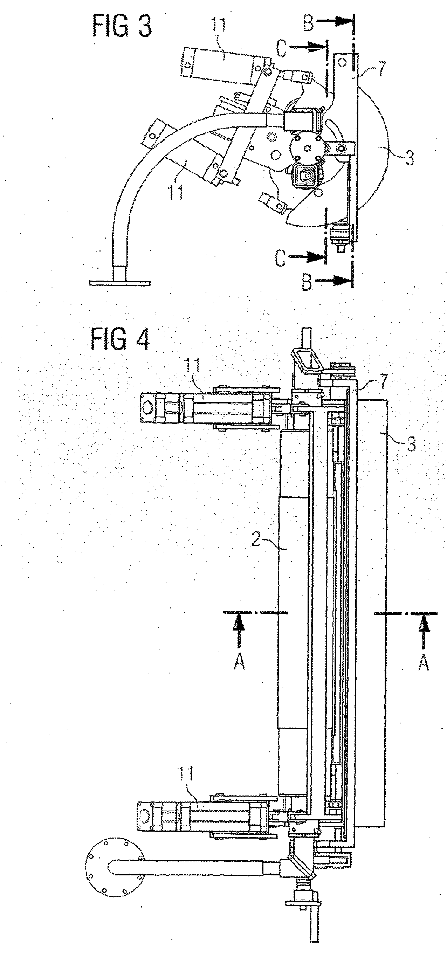

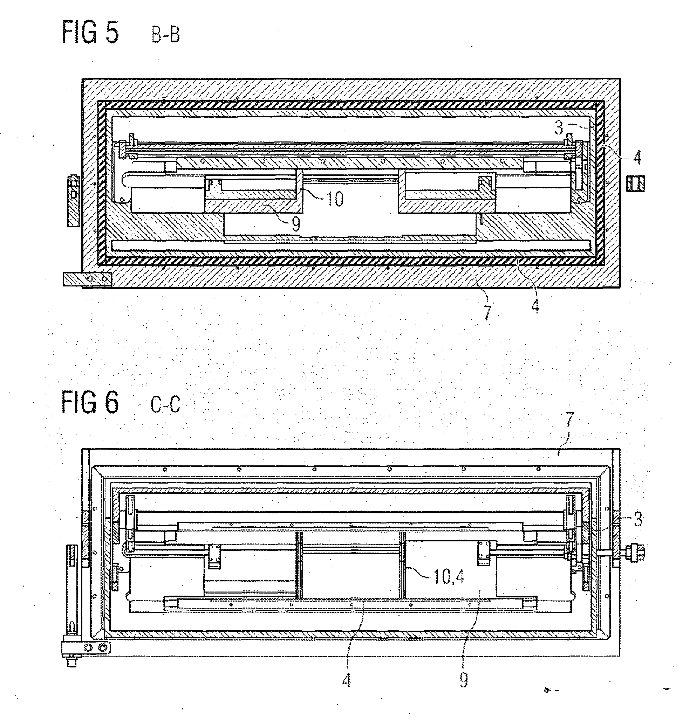

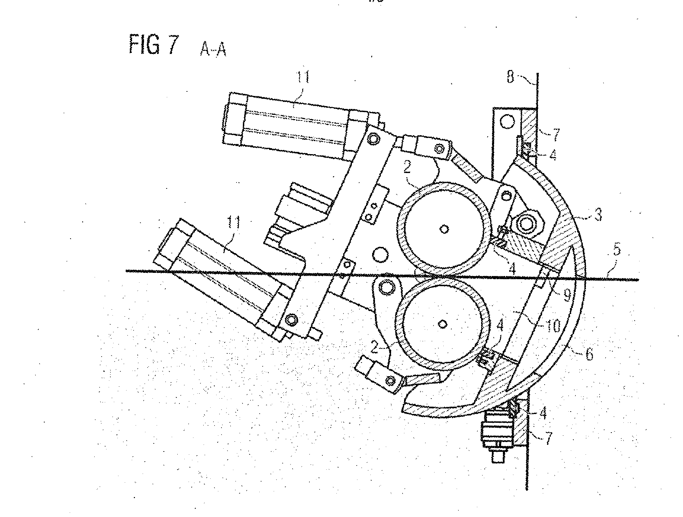

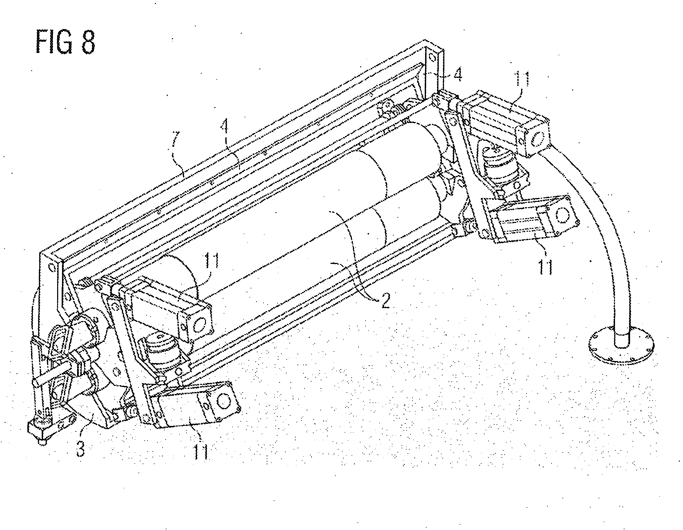

Die Fig. 3 bis 8 zeigen ein weiteres Ausführungsbeispiel der erfindungsgemäßen Schleuseneinrichtung in verschiedenen Ansichten und Schnittdarstellungen. Die Schleuseneinrichtung umfasst ein in einem Ausschnitt einer Flanschplatte 7 drehbar gelagertes Hohlzylindersegment 3, an dem zwei ebenfalls um je eine Rotationsachse drehbar gelagerte Rollen 2 angeordnet sind. An den Rändern des Ausschnitts der Flanschplatte 7 sind Dichtmittel 4 so angeordnet, dass sowohl die Mantelfläche wie auch die beiden Stirnseiten des Hohlzylindersegments 3 wirksam gegenüber dem Hohlzylindersegment 3 abgedichtet sind. Weiterhin sind zwischen den Mantelflächen der Rollen 2 und dem Hohlzylindersegment 3 Dichtmittel vorgesehen, die an diesen Stellen für eine vakuumdichte Abdichtung der Rollen gegenüber dem Hohlzylindersegment 3 sorgen.

Die Achse, um die das Hohlzylinderelement 3 drehbar gelagert ist, ist seine zentrale Symmetrieachse. Diese entspricht gleichzeitig der Berührungslinie der beiden Rollen 2.

Die Flanschplatte 7 ist so gestaltet, dass sie an einer Schottwand 8 einer Vakuumkammer 1 anbringbar ist. Das Hohlzylindersegment 3 weist eine Transferöffnung 6 auf, durch die das bandförmige Substrat 5 hindurchgeführt wird. Die Drehung des Hohlzylindersegments 3 wird durch ein erstes Paar von Hydraulikzylindern 11 bewirkt. Mit einer Verdrehung des Hohlzylindersegments 3 wird auch das Rollenpaar relativ zur Transportrichtung des bandförmigen Substrats 5 verdreht, so dass der Umschlingungswinkel eingestellt werden kann.

Darüber hinaus ist der Abstand der Rollen 2 zueinander durch eine Relativbewegung zwischen ihnen veränderbar, so dass der Abstand zwischen den Rollen 2 für verschiedene Substratdicken bzw. zum Öffnen der Schleuseneinrichtung einstellbar ist.

Zur Verstellung des Abstands zwischen den Rollen 2 ist ein zweites Paar von Pneumatikzylindern 11 vorgesehen, das gleichzeitig dafür genutzt werden kann, zwischen den Rollen 2 eine Andruckkraft zu erzeugen, deren Richtung im Wesentlichen der Verbindungslinie der Rotationsachsen beider Rollen 2 entspricht.

Im Hohlzylindersegment 3 sind zwei beweglich gelagerte Blenden 9 so angeordnet, dass die Breite der Transferöffnung 6 durch Verschiebung der Blenden 9 in Abhängigkeit von der Breite des bandförmigen Substrats 5 veränderbar ist, um möglichst geringe Spalte beidseitig des bandförmigen Substrats 5 zu erhalten, die sich negativ auf das Druckgefälle zwischen den beiden Seiten der Schleuseneinrichtung auswirken würden. Die Blenden 9 weisen je eine Seitenwange 10 auf, die komplementär zum Querschnitt des Rollenpaares gestaltet sind, d. h. die Seitenwange 10 hat eine etwa keilförmige Gestalt, so dass sie zwischen die Rollen 2 greift. An den Flanken der Seitenwangen 10, die mit den Mantelflächen der Rollen 2 in Berührung stehen, sind weitere Dichtmittel 4 vorgesehen. Die Blenden 9 sind gegenüber dem Hohlzylindersegment 3 ebenfalls durch Dichtmittel 4 abgedichtet. Dadurch wird eine sichere Abdichtung der Rollen 2 zu den Seitenwangen 10 der Blenden 9 auch senkrecht zur Ebene des bandförmigen Substrats 5 sowie der Blenden 9 zum Hohlzylindersegment 3 erreicht.

Der Kern der vorliegenden Erfindung wird darin gesehen, dass jede einzelne Schleuseneinrichtung bzw. das zu dieser Schleuseneinrichtung gehörende Rollenpaar um eine Achse relativ zum Behälter der Eingangs- bzw. Ausgangsschleuse der Vakuumkammer 1 und damit zur Transportrichtung des bandförmigen Substrats 5 gedreht wird. Dadurch kann der Umschlingungswinkel des bandförmigen Substrats 5 um die Rollen 2 variiert werden. Die Variation des Umschlingungswinkels ermöglicht somit folgende Optionen:
Bei vergleichsweise dünnen bandförmigen Substraten 5 können große Umschlingungswinkel des bandförmigen Substrats 5 um die Rollen 2 dargestellt werden, wie in Fig. 1 gezeigt. Die Bandzugkraft kann somit so gering gewählt werden, dass das bandförmige Substrat 5 ohne Schädigung (z. B. plastische Verformung oder Bandriss) gezogen wird und dass die erforderliche Traktion zwischen dem bandförmigen Substrat 5 und den Rollen 2 dennoch gegeben ist.
Bei vergleichsweise dicken bandförmigen Substraten 5 können kleine Umschlingungswinkel des bandförmigen Substrats 5 um die Rollen 2 dargestellt werden, wie in Fig. 2 gezeigt. Die vergleichsweise geringe Umschlingung erlaubt hier die Auswahl eines kleineren Durchmessers der Rollen 2 ohne dass das bandförmige Substrat 5 geschädigt wird (z. B. durch Überstreckung während des Anliegens an der Rolle 2).

Eine Abdichtung zur Minimierung von Leckagen erfolgt dabei zwischen dem Hohlzylindersegment 3 der Schleuseneinrichtung und der Vakuumkammer 1, zwischen den Rollen 2 und dem Hohlzylindersegment 3 und zwischen dem bandförmigen Substrat 5 und den Rollen 2 sowie gegebenenfalls zwischen den Blenden 9 und dem Hohlzylindersegment 3 und zwischen den Rollen 2 und den Seitenwangen 10.

Die geometrische Zuordnung des Rollenpaars einer Schleuseneinrichtung bleibt dabei mit Ausnahme der unten beschriebenen Funktion während des Durchführens von Bandstößen unverändert, was sich sehr günstig auf die Minimierung von Leckagen (Abdichtung zwischen den Rollen 2 und dem Hohlzylindersegment 3) auswirkt.

Durch das erfindungsgemäße Verfahren wird der Umschlingungswinkel zwischen dem bandförmigen Substrat 5 und jeder Rolle 2 durch Verdrehung des Rollenpaars relativ zur Transportrichtung des bandförmigen Substrats 5 so eingestellt, dass zwischen dem bandförmigen Substrat 5 und den Rollen 2 eine für einen synchronen Antrieb des Rollenpaares ausreichende Traktion erzeugt wird, ohne dass das bandförmige Substrat 5 durch zu starke Verformungen oder zu hohe Bandzugkräfte beschädigt wird.

Aufgrund der durch das Verfahren geschaffenen Möglichkeit einer Anpassung der Schleuseneinrichtung an verschiedene Bandbreiten entfällt die Notwendigkeit, die Eingangschleusen- bzw. Ausgangsschleusenbehälter der Vakuumkammer 1 zu belüften. Der Transport des bandförmigen Substrats 5 muss nicht verlangsamt oder gestoppt werden.

Die Rollen 2 jeder einzelnen Schleuseneinrichtung können in eine Position bewegt werden, die ein berührungsloses Durchführen des bandförmigen Substrats 5 durch diese eine Schleuseneinrichtung gestatten.

Die Rollen 2 der erfindungsgemäßen Schleuseneinrichtung sind so gelagert, dass der Einfluss durch unterschiedlichen (Luft)druck vor bzw. nach einer einzelnen Schleuseneinrichtung kompensiert wird.

Die Schleuseneinrichtung kann so ausgeführt sein, dass die Rollen 2 beim Kontakt mit Bandstößen, d. h. zwei miteinander verbundenen Enden des bandförmigen Substrats 5, automatisch öffnen ohne den Prozessdruck innerhalb der Vakuumkammer 1 zwischen einer Eingangsschleusensektion und einer Ausgangsschleusensektion zu beeinflussen.

### Bezugszeichenliste

- 1: Vakuumkammer
- 2: Rolle
- 3: Hohlzylindersegment
- 4: Dichtmittel
- 5: bandförmiges Substrat
- 6: Transferöffnung
- 7: Flanschplatte
- 8: Schottwand
- 9: Blende
- 10: Seitenwange
- 11: Pneumatikzylinder

## Patentansprüche

1. Verfahren zur Abdichtung einer Vakuumkammer (1) gegen Atmosphäre, bei dem ein bandförmiges Substrat (5) durch die Vakuumkammer (1) transportiert wird, wobei das bandförmige Substrat (5) zwischen zwei um je eine Rotationsachse drehbar gelagerten Rollen (2) eines Rollenpaares hindurchgeführt wird, die mit einem eine Bandpassage für das bandförmige Substrat (5) bildenden Abstand zueinander angeordnet sind, **dadurch gekennzeichnet, dass** der Umschlingungswinkel zwischen dem bandförmigen Substrat (5) und jeder Rolle (2) durch Verdrehen des Rollenpaars relativ zur Transportrichtung des bandförmigen Substrats (5) so eingestellt wird, dass die zwischen dem bandförmigen Substrat (5) und den Rollen (2) wirkenden Reibungskräfte eine Rotationsbewegung der Rollen (2) hervorrufen, bei der die Umfangsgeschwindigkeit der Rollen (2) im Wesentlichen gleich der Transportgeschwindigkeit des bandförmigen Substrats (5) ist.

2. Verfahren nach Anspruch 1, **dadurch gekennzeichnet, dass** der Abstand zwischen den Rollen (2) durch eine Bewegung mindestens einer Rolle (2) eines Rollenpaares relativ zur anderen Rolle (2) des Rollenpaares an die Dicke des bandförmigen Substrats (5) angepasst wird.

3. Verfahren nach Anspruch 2, **dadurch gekennzeichnet, dass** die relative Bewegung der mindestens einen Rolle (2) eine Verschiebung ist.

4. Verfahren nach Anspruch 2, **dadurch gekennzeichnet, dass** die relative Bewegung der mindestens einen Rolle (2) eine Schwenkbewegung um eine außerhalb der Rotationsachse der Rolle (2) liegende Schwenkachse ist.

5. Verfahren nach einem der vorhergehenden Ansprüche, **dadurch gekennzeichnet, dass** zur Anpassung des Abstandes an ungleichmäßig dicke bandförmige Substrate (5) mindestens eine Rolle (2) eines Rollenpaares mit einer Andruckkraft beaufschlagt wird, deren Richtung im Wesentlichen der Verbindungslinie zwischen den Rotationsachsen der beiden Rollen (2) entspricht.

6. Verfahren nach einem der vorhergehenden Ansprüche, **dadurch gekennzeichnet, dass** das bandförmige Substrat (5) durch mindestens zwei hintereinander angeordnete Rollenpaare hindurchgeführt wird.

7. Verfahren nach Anspruch 6, **dadurch gekennzeichnet, dass** die Verdrehung jedes Rollenpaares relativ zur Transportrichtung des bandförmigen Substrats (5) separat eingestellt wird.

8. Verfahren nach einem der vorhergehenden Ansprüche, **dadurch gekennzeichnet, dass** die Verdrehung jedes Rollenpaares gesteuert wird.

9. Verfahren nach einem der vorhergehenden Ansprüche, **dadurch gekennzeichnet, dass** die Verdrehung jedes Rollenpaares geregelt wird.

10. Verfahren nach Anspruch 8 oder 9, **dadurch gekennzeichnet, dass** die Steuerung bzw. Regelung in Abhängigkeit von der Bandzugkraft erfolgt.

11. Verfahren nach einem der vorhergehenden Ansprüche, **dadurch gekennzeichnet, dass** die Breite der Bandpassage für das bandförmige Substrat (5) auf einen Wert eingestellt wird, der im Wesentlichen der tatsächlichen Breite des bandförmigen Substrats (5) entspricht.

12. Verfahren nach Anspruch 11, **dadurch gekennzeichnet, dass** die Einstellung der Breite der Bandpassage durch Verschieben mindestens einer verschiebbaren Blende (9) erfolgt.

13. Schleuseneinrichtung für eine Vakuumkammer (1) zur Behandlung eines bandförmigen Substrats (5), umfassend mindestens ein Rollenpaar, das von zwei um je eine Rotationsachse drehbar gelagerten Rollen (2) gebildet ist, wobei die Rollen (2) mit einem eine Bandpassage für das bandförmige Substrat (5) bildenden Abstand zueinander angeordnet sind, **dadurch gekennzeichnet, dass** das Rollenpaar relativ zur Transportrichtung des bandförmigen Substrats (5) drehbar gelagert ist.

14. Schleuseneinrichtung nach Anspruch 13, **dadurch gekennzeichnet, dass** beide Rollen (2) eines Rollenpaares in einem relativ zur Transportrichtung des bandförmigen Substrats (5) drehbar gelagerten Hohlzylindersegment (3) mit einer Transferöffnung (6) für das bandförmige Substrat (5) gelagert sind.

15. Schleuseneinrichtung nach Anspruch 14, **dadurch gekennzeichnet, dass** das Hohlzylindersegment (3) in einem Ausschnitt einer Flanschplatte (7), die zur Anbringung an einer Schottwand (8) der Vakuumkammer (1) ausgebildet ist, so gelagert ist, dass seine Außenseite bei einer Verdrehung in ständigem Kontakt mit den Rändern des Ausschnitts steht.

16. Schleuseneinrichtung nach Anspruch 15, **dadurch gekennzeichnet, dass** an den Rändern des Ausschnitts Dichtmittel (4) zur Abdichtung des Hohlzylindersegments (3) gegenüber der Flanschplatte (7) vorgesehen sind.

17. Schleuseneinrichtung nach einem der Ansprüche 14 bis 16, **dadurch gekennzeichnet, dass** das Hohlzylindersegment (3) weiterhin Dichtmittel (4) zur Abdichtung der Rollen (2) gegenüber dem Hohlzylindersegment (3) aufweist.

18. Schleuseneinrichtung nach einem der Ansprüche 14 bis 17, **dadurch gekennzeichnet, dass** das Hohlzylindersegment (3) mindestens eine beweglich gelagerte Blende (9) zur Einstellung der Breite der Transferöffnung (6) aufweist.

19. Schleuseneinrichtung nach Anspruch 18, **dadurch gekennzeichnet, dass** an der mindestens einen beweglich gelagerten Blende (9) eine Seitenwange (10) vorgesehen ist, die eine zum Querschnitt des Rollenpaares komplementäre Form aufweist.

20. Schleuseneinrichtung nach einem der Ansprüche 13 bis 19, **dadurch gekennzeichnet, dass** mindestens eine Rolle (2) des Rollenpaares relativ zur anderen Rolle (2) des Rollenpaares zur Anpassung des Abstands an die Dicke des bandförmigen Substrats (5) bewegbar ist.

21. Schleuseneinrichtung nach Anspruch 20, **dadurch gekennzeichnet, dass** die bewegbare Rolle (2) verschiebbar gelagert ist.

22. Schleuseneinrichtung nach Anspruch 20, **dadurch gekennzeichnet, dass** die bewegbare Rolle (2) um eine außerhalb der Rotationsachse dieser Rolle (2) liegende Schwenkachse schwenkbar gelagert ist.

23. Schleuseneinrichtung nach einem der Ansprüche 13 bis 22, **dadurch gekennzeichnet, dass** zur Anpassung des Abstandes an ungleichmäßig dicke bandförmige Substrate (5) mindestens eine Rolle (2) eines Rollenpaares mit einer Andruckkraft beaufschlagbar ist, deren Richtung im Wesentlichen der Verbindungslinie zwischen den Rotationsachsen der beiden Rollen (2) entspricht.

24. Schleuseneinrichtung nach Anspruch 23, **dadurch gekennzeichnet, dass** zur Erzeugung der Andruckkraft mindestens ein Pneumatikzylinder (11) vorgesehen ist.

25. Schleuseneinrichtung nach Anspruch 23 oder 24, **dadurch gekennzeichnet, dass** zur Erzeugung der Andruckkraft mindestens eine Feder vorgesehen ist.

26. Schleuseneinrichtung nach einem der Ansprüche 13 bis 25, **dadurch gekennzeichnet, dass** mindestens zwei hintereinander angeordnete Rollenpaare vorgesehen sind.

27. Schleuseneinrichtung nach Anspruch 26, **dadurch gekennzeichnet, dass** die Verdrehung jedes Rollenpaares relativ zur Transportrichtung des bandförmigen Substrats (5) separat einstellbar ist.

28. Schleuseneinrichtung nach Anspruch 26 oder 27, **dadurch gekennzeichnet, dass** der Abstand der Rollen (2) jedes Rollenpaares zueinander separat einstellbar ist.

29. Schleuseneinrichtung nach einem der Ansprüche 13 bis 28, **dadurch gekennzeichnet, dass** weiterhin Mittel zur Steuerung der Verdrehung jedes Rollenpaares vorgesehen sind.

30. Schleuseneinrichtung nach einem der Ansprüche 13 bis 29, **dadurch gekennzeichnet, dass** weiterhin Mittel zur Regelung der Verdrehung jedes Rollenpaares vorgesehen sind.

31. Schleuseneinrichtung nach einem der Ansprüche 13 bis 30, **dadurch gekennzeichnet, dass** weiterhin Mittel zur Messung der Bandzugkraft des bandförmigen Substrats (5) vorgesehen sind.

32. Schleuseneinrichtung nach einem der Ansprüche 13 bis 31, **dadurch gekennzeichnet, dass** zur Drehung des Rollenpaares bzw. des Hohlzylindersegments (3) mindestens ein Pneumatikzylinder (11) vorgesehen ist.

## Claims

1. A method for sealing a vacuum chamber (1) from the external atmosphere, wherein a strip-like substrate (5) is transferred through said vacuum chamber (1), said strip-like substrate (5) being passed between two rollers (2) of a pair of rollers which are rotatably mounted and which are arranged with a spacing that defines a strip passage for said strip-like substrate (5),
**characterized in that** a wrapping angle between said strip-like substrate (5) and each of said rollers (2) is adjusted by twisting the pair of rollers relative to the transfer direction of said strip-like substrate (5) such that a rotational movement of said rollers (2) is caused by friction forces acting between said strip-like substrate (5) and said rollers (2), and wherein a circumferential speed of the rollers (2) is substantially equal to the transfer rate of said strip-like substrate (5).

2. The method of claim 1, **characterized in that** the spacing between said rollers (2) is adapted to the thickness of said strip-like substrate (5) by moving at least one roller (2) of the pair of rollers relative to the other roller (2) of the pair of rollers.

3. The method of claim 2, **characterized in that** said relative movement of said at least one roller (2) is a translational movement.

4. The method of claim 2, **characterized in that** said relative movement of said at least one roller (2) is a pivotal movement around a pivotal axis which is not coincident with the rotational axis of said roller (2).

5. The method of any of the preceding claims, **characterized in that** for adapting said spacing to strip-like substrates (5) of non-uniform thicknesses a pressing force is applied to at least one roller (2) of a pair of rollers in a direction that substantially corresponds to the connecting line between the rotational axes of said pair of rollers (2).

6. The method of any of the preceding claims, **characterized in that** said strip-like substrate (5) is passed between at least two pairs of rollers which pairs are disposed one following the other.

7. The method of claim 6 **characterized in that** the amount of twist of each pair of rollers relative to the transfer direction of said strip-like substrate (5) is adjusted separately from the other.

8. The method of any of the preceding claims, **characterized in that** the amount of twist of each pair of rollers is controlled.

9. The method of any of the preceding claims, **characterized in that** the amount of twist of each pair of rollers is closed-loop controlled.

10. The method of claim 8 or 9, **characterized in that** said controlling or closed-loop controlling is performed in function of the strip traction force.

11. The method of any of the preceding claims, **characterized in that** the width of the strip passage for said strip-like substrate (5) is adjusted to an amount that substantially corresponds to an effective width of said strip-like substrate (5).

12. The method of claim 11, **characterized in that** adjusting the width of said strip passage is performed by displacing at least one moveable screen (9).

13. A sluice device for a vacuum chamber (1) for treating a strip-like substrate (5), including at least one pair of rollers comprised of two rollers (2) each of which is mounted for rotation around a rotational axis, said rollers (2) being arranged with a spacing that defines a strip passage for said strip-like substrate (5),
**characterized in that**
said pair of rollers is mounted twistably relative to the transfer direction of said strip-like substrate (5).

14. The sluice device of claim 13, **characterized in that** each roller (2) of a pair of rollers is mounted in a hollow cylinder segment (3) which is mounted for rotation relative to the transfer direction of said strip-like substrate (5) and which has a transfer opening (6) for said strip-like substrate (5).

15. The sluice device of claim 14, **characterized in that** said hollow cylinder segment (3) is mounted in a recess of a flange plate (7) which is adapted for being attached to a separation wall (8) of said vacuum chamber (1), such that, while being twisted, an outer surface of said hollow cylinder segment continually engages the edges of said recess.

16. The sluice device of claim 15, **characterized in that** sealing means (4) are provided at the edges of said recess to seal said hollow cylinder segment (3) against said flange plate (7).

17. The sluice device according to any of claims 14 to 16, **characterized in that** said hollow cylinder segment (3) further comprises sealing means (4) for sealing said rollers (2) against said hollow cylinder segment (3).

18. The sluice device according to any of claims 14 to 17, **characterized in that** said hollow cylinder segment (3) comprises at least one screen (9) which is slidably mounted for adjusting the width of said transfer opening (6).

19. The sluice device of claim 18, **characterized in that** said at least one slidably mounted screen (9) has a side flange (10) with a shape complementary to that of a cross section of said pair of rollers.

20. The sluice device according to any of claims 13 to 19, **characterized in that** at least one roller (2) of said pair of rollers is moveable relative to the other roller (2) of said pair of rollers for adjusting the spacing thereof to the thickness of said strip-like substrate (5).

21. The sluice device of claim 20, **characterized in that** said moveable roller (2) is displaceably mounted.

22. The sluice device of claim 20, **characterized in that** said moveable roller (2) is mounted for pivotal movement around a pivotal axis which is not coincident with the rotational axis thereof.

23. The sluice device according to any of claims 13 to 22, **characterized in that**, for adapting said spacing to strip-like substrates (5) of non-uniform thicknesses, a pressing force can be applied to at least one roller (2) of a pair of rollers in a direction that substantially corresponds to the connecting line between the rotational axes of said pair of rollers (2).

24. The sluice device of claim 23, **characterized in that** a pneumatic cylinder (11) is provided for generating said pressing force.

25. The sluice device of claim 23 or claim 24, **characterized in that** at least one spring is provided for generating said pressing force.

26. The sluice device according to any of claims 13 to 25, **characterized in that** at least two pairs of rollers are provided which pairs are disposed one following the other.

27. The sluice device of claim 26, **characterized in that** the amount of twist of each pair of rollers relative to the transfer direction of said strip-like substrate (5) is separately adjustable.

28. The sluice device of claim 26 or claim 27, **characterized in that** the spacing of the rollers (2) of each pair of rollers is adjustable separately from each other.

29. The sluice device according to any of claims 13 to 28, **characterized in that** it further comprises means for controlling the amount of twist of each pair of rollers.

30. The sluice device according to any of claims 13 to 29, **characterized in that** it further comprises means for closed-loop controlling the amount of twist of each pair of rollers.

31. The sluice device according to any of claims 13 to 30, **characterized in that** it further comprises means for measuring a strip traction force of said strip-like substrate (5).

32. The sluice device according to any of claims 13 to 31, **characterized in that** it further comprises at least one pneumatic cylinder (11) for twisting said pair of rollers or said hollow cylinder segments (3).

## Revendications

1. Procédé pour l'étanchement d'une chambre à vide (1) vis-à-vis de l'atmosphère, dans lequel un substrat en bande (5) est transporté à travers la chambre à vide (1), le substrat en bande (5) étant autorisé à passer entre deux rouleaux (2) logés chacun de manière pivotable autour de l'axe de rotation d'une paire de rouleaux qui sont disposés l'un par rapport à l'autre avec une distance formant un passage pour la bande pour le substrat en bande (5), **caractérisé en ce que** l'angle d'enroulement entre le substrat en bande (5) et chaque rouleau (2) est réglé par rotation de la paire de rouleaux relativement au sens de transport du substrat en bande (5) de manière telle que les forces de friction qui agissent entre le substrat en bande (5) et les rouleaux (2) entraînent un mouvement de rotation des rouleaux (2) pour lequel la vitesse périphérique des rouleaux (2) est égal essentiellement à la vitesse de transport du substrat en bande (5).

2. Procédé selon la revendication 1, **caractérisé en ce que** la distance entre les rouleaux (2) relativement à l'autre rouleau (2) de la paire de rouleaux est adaptée à l'épaisseur du substrat en bande (5) par le mouvement d'au moins un rouleau (2) d'une paire de rouleaux.

3. Procédé selon la revendication 2, **caractérisé en ce que** le mouvement relatif d'au moins un rouleau (2) est une translation.

4. Procédé selon la revendication 2, **caractérisé en ce que** le mouvement relatif d'au moins un rouleau (2) est un mouvement pivotant autour d'un axe de pivotement situé à l'extérieur de l'axe de rotation du rouleau (2).

5. Procédé selon l'une des revendications qui précèdent, **caractérisé en ce que**, pour l'adaptation de la distance, au moins un rouleau (2) d'une paire de rouleaux est alimenté en substrats (5) en bande d'épaisseur inégale avec un effort de compression dont la direction correspond essentiellement à la ligne de liaison entre les axes de rotation des deux rouleaux (2).

6. Procédé selon l'une des revendications qui précèdent, **caractérisé en ce que** le substrat en bande (5) est au moins autorisé à passer par deux paires de rouleaux disposées l'une derrière l'autre.

7. Procédé selon la revendication 6, **caractérisé en ce que** la torsion de chaque paire de rouleaux est réglée séparément par rapport au sens de transport du substrat en bande (5).

8. Procédé selon l'une des revendications qui précèdent, **caractérisé en ce que** la torsion de chaque paire de rouleaux est commandée.

9. Procédé selon l'une des revendications qui précèdent, **caractérisé en ce que** la torsion de chaque paire de rouleaux est régulée.

10. Procédé selon la revendication 8 ou 9, **caractérisé en ce que** la commande ou la régulation a lieu en fonction de la force de traction de la bande.

11. Procédé selon l'une des revendications qui précèdent, **caractérisé en ce que** la largeur du passage de bande pour le substrat en bande (5) est réglée sur une valeur qui correspond essentiellement à la largeur réelle du substrat en bande (5).

12. Procédé selon la revendication 11, **caractérisé en ce que** le réglage de la largeur du passage de bande a lieu par translation d'au moins un diaphragme (9) susceptible de translation.

13. Dispositif à sas pour une chambre à vide (1) pour le traitement d'un substrat en bande (5), comprenant au moins une paire de rouleaux qui est formée par deux rouleaux (2) logés de manière pivotable autour d'un axe de rotation, les rouleaux (2) étant disposés l'un par rapport à l'autre avec une distance formant un passage de bande pour le substrat en bande (5), **caractérisé en ce que** la paire de rouleaux est logée de manière pivotable relativement au sens de transport du substrat en bande (5).

14. Dispositif à sas selon la revendication 13, **caractérisé en ce que** les deux rouleaux (2) d'une paire de rouleaux sont logés dans un segment de cylindre creux (3) logé de manière pivotable relativement au sens de transport du substrat en bande (5) avec une ouverture de transfert (6) pour le substrat en bande (5).

15. Dispositif à sas selon la revendication 14, **caractérisé en ce que** le segment de cylindre creux (3) est formé dans la section d'une plaque de bride (7) qui est formée pour une application sur une cloison étanche (8) de la chambre à vide (1), de manière telle que sa face extérieure est, en cas de torsion, en contact constant avec les bords de la section.

16. Dispositif à sas selon la revendication 15, **caractérisé en ce que**, sur les bords de la découpe, des moyens d'étanchéité (4) sont prévus pour l'étanchement du segment de cylindre creux (3) vis-à-vis de la plaque de bride (7).

17. Dispositif à sas selon l'une des revendications 14 à 16, **caractérisé en ce que** le segment de cylindre creux (3) présente, en outre, des moyens d'étanchéité (4) pour l'étanchement des rouleaux (2) vis-à-vis du segment de cylindre creux (3).

18. Dispositif à sas selon l'une des revendications 14 à 17, **caractérisé en ce que** le segment de cylindre creux (3) présente au moins un diaphragme (9) logé de manière mobile pour le réglage de la largeur de l'ouverture de transfert (6).

19. Dispositif à sas selon la revendication 18, **caractérisé en ce qu'**il est prévu, sur au moins un diaphragme logé de manière mobile (9), une joue latérale (10) qui présente une forme complémentaire par rapport à la section de la paire de rouleaux.

20. Dispositif à sas selon l'une des revendications 13 à 19, **caractérisé en ce qu'**au moins un rouleau (2) de la paire de rouleaux (2) est mobile relativement à l'autre rouleau (2) de la paire de rouleaux pour l'adaptation de la distance à l'épaisseur du substrat en bande (5).

21. Dispositif à sas selon la revendication 20, **caractérisé en ce que** le rouleau mobile (2) est logé de manière à pouvoir exécuter un mouvement de translation.

22. Dispositif à sas selon la revendication 20, **caractérisé en ce que** le rouleau mobile (2) est logé de manière pivotable autour d'un axe de pivotement situé à l'extérieur de l'axe de rotation de ce rouleau (2).

23. Dispositif à sas selon l'une des revendications 13 à 22, **caractérisé en ce que** pour l'adaptation de la distance à des substrats en bande d'épaisseur inégale (5), au moins un rouleau (2) d'une paire de rouleaux peut être alimenté par un effort de compression dont le sens correspond essentiellement à la ligne de liaison entre les axes de rotation des deux rouleaux (2).

24. Dispositif à sas selon la revendication 23, **caractérisé en ce que** pour la production de l'effort de compression, au moins un cylindre pneumatique (11) est prévu.

25. Dispositif à sas selon la revendication 23 ou 24, **caractérisé en ce que** pour la production de l'effort de compression, au moins un ressort est prévu.

26. Dispositif à sas selon l'une des revendications 13 à 25, **caractérisé en ce que** au moins deux paires de rouleaux disposées l'une derrière l'autre sont prévues.

27. Dispositif à sas selon la revendication 26, **caractérisé en ce que** la torsion de chaque paire de rouleaux est réglable séparément par rapport au dispositif de transport du substrat en bande (5).

28. Dispositif à sas selon la revendication 26 ou 27, **caractérisé en ce que** la distance mutuelle des rouleaux (2) de chaque paire de rouleaux est réglable séparément.

29. Dispositif à sas selon l'une des revendications 13 à 28, **caractérisé en ce que** des moyens sont également prévus pour la commande de la torsion de chaque paire de rouleaux.

30. Dispositif à sas selon l'une des revendications 13 à 29, **caractérisé en ce que** des moyens sont également prévus pour la régulation de la torsion de chaque paire de rouleaux.

31. Dispositif à sas selon l'une des revendications 13 à 30, **caractérisé en ce que** des moyens sont également prévus pour la mesure de l'effort de traction de bande du substrat en bande (5).

32. Dispositif à sas selon l'une des revendications 13 à 31, **caractérisé en ce que** pour la rotation de la paire de rouleaux ou du segment de cylindre creux (3), au moins un cylindre pneumatique (11) est prévu.
